# EUROPÄISCHE PATENTSCHRIFT

(11) **EP 3 339 885 B1**
(45) Veröffentlichungstag und Bekanntmachung des Hinweises auf die Patenterteilung: **20.08.2025**
(21) Anmeldenummer: 16205847.3
(22) Anmeldetag: 21.12.2016
(51) Int. Cl.: G01S 7/486, H03M 1/12, H03M 1/14, H03M 1/10, G01S 17/10

(54) **LASERDISTANZMESSMODUL MIT INL-FEHLERKOMPENSATION**
LASER DISTANCE MEASURING MODULE WITH INL ERROR COMPENSATION
MODULE TÉLÉMÉTRIQUE LASER COMPRENANT UNE COMPENSATION D'ERREUR INL

(43) Veröffentlichungstag der Anmeldung: 27.06.2018
(73) Patentinhaber: Hexagon Technology Center GmbH, 9435 Heerbrugg (CH)
(72) Erfinder: BESTLER, Simon, D-88085 Langenargen (DE); WOHLGENANNT, Rainer, A-6833 Klaus (AT); HINDERLING, Jürg, CH-9437 Marbach (CH)
(74) Vertreter: Kaminski Harmann

(56) Entgegenhaltungen:
- EP-A2- 1 160 585
- MALKIEWICZ: "Improvement of intelligent cyclic ADC resolution by randomization of DAC INL errors", PHOTONICS APPLICATIONS IN ASTRONOMY, COMMUNICATIONS, INDUSTRY, AND HIGH-ENERGY PHYSICS EXPERIMENTS 2012, PROCEEDINGS OF THE SPIE, vol. 8454, 15 October 2012 (2012-10-15), pages 84540Z - 84540Z, XP060029026, ISBN: 978-1-62841-730-2, DOI: 10.1117/12.2000245

## Beschreibung

Die vorliegende Erfindung betrifft eine Distanzmessmethode und ein elektronisches Laserdistanzmessmodul, insbesondere zur Verwendung in einem Distanzmessgerät, z.B. in einem Lasertracker, Tachymeter, Laserscanner, oder Profiler, zur schnellen Signalerfassung mit einem Analog-Digital-Wandler, wobei eine Kompensation der Integralen Nichtlinearität des Analog-Digital-Wandlers erfolgt.

Im Bereich der elektronischen bzw. elektrooptischen Distanzmessung sind verschiedene Prinzipien und Verfahren bekannt. Ein Ansatz besteht darin, gepulste elektromagnetische Strahlung, wie z.B. Laserlicht, auf ein zu vermessendes Ziel auszusenden und nachfolgend ein Echo von diesem Ziel als rückstreuendem Objekt zu empfangen, wobei die Distanz zum zu vermessenden Ziel beispielsweise anhand der Laufzeit, der Form, und/oder der Phase des Pulses bestimmt werden kann. Solche Laserdistanzmesser haben sich mittlerweile in vielen Bereichen als Standardlösungen durchgesetzt.

Zur Detektion des zurückgestreuten Pulses werden zumeist zwei unterschiedliche Ansätze oder eine Kombination daraus verwendet.

Bei der so genannten Schwellwertmethode wird ein Lichtpuls detektiert, wenn die Intensität der auf einen Detektor des eingesetzten Distanzmessgeräts einfallenden Strahlung einen gewissen Schwellwert überschreitet. Durch diesen Schwellwert wird verhindert, dass Rauschen und Störsignale aus dem Hintergrund fälschlich als Nutzsignal, d.h. als rückgestreutes Licht des emittierten Pulses, detektiert werden.

Der andere Ansatz basiert auf der Abtastung bzw. dem Sampling des rückgestreuten Pulses. Dieser Ansatz wird typischerweise bei schwachen rückgestreuten Signalen (z.B. Pulssignale) verwendet, wie sie beispielsweise durch grössere Messdistanzen bedingt werden, oder allgemein für eine Erhöhung der Messgenauigkeit. Ein emittiertes Signal wird detektiert, indem die von einem Detektor erfasste Strahlung abgetastet, innerhalb des abgetasteten Bereichs ein Signal identifiziert und schliesslich eine Lage des Signals zeitlich bestimmt wird. Durch die Verwendung einer Vielzahl von Abtastwerten und/oder zur Emissionsrate synchronem Aufsummieren des Empfangssignals kann ein Nutzsignal auch unter ungünstigen Umständen identifiziert werden, so dass auch grössere Distanzen oder verrauschte bzw. mit Störungen behaftete Hintergrundszenarien bewältigt werden können.

Heutzutage wird dabei mittels der Wellenformdigitalisierungsmethode ("Waveform Digitizing", WFD) häufig die gesamte Wellenform des analogen Signals der von einem Detektor erfassten Strahlung abgetastet. Nach Identifikation der Codierung des zugehörigen Sendesignals (ASK, FSK, PSK, etc.) eines empfangenen Signals, wird aus einem definierten Verlaufspunkt des abgetasteten, digitalisierten und rekonstruierten Signals, beispielsweise den Wendepunkten, den Kurvenmaxima, oder integral mittels eines aus der Zeitinterpolation bekannten Optimum Filters, sehr genau eine Signallaufzeit ("Pulslaufzeit") bestimmt.

Alternativ oder zusätzlich zur Bestimmung der Pulslaufzeit erfolgt eine (schnelle) Abtastung oft auch hinsichtlich in Amplitude, Phase, Polarisation, Wellenlänge und/oder Frequenz codierten oder modulierten Impulsen oder Impulsfolgen.

Beim Ansatz der zeitlich sehr präzisen Abtastung bzw. dem Sampling des zurückgestreuten Signals wird das vom Detektor erzeugte elektrische Signal mittels eines Analog-Digital-Wandlers ("Analog-Digital-Converter", ADC) in eine digitale Signalfolge umgewandelt. Dieses digitale Signal wird anschliessend meistens in Echtzeit weiter verarbeitet. In einem ersten Schritt wird das Signal, oft als Impuls moduliert, durch spezielle digitale Filter erkannt und schliesslich dessen Lage innerhalb der Signalfolge bestimmt. Durch die Verwendung einer Vielzahl von abgetasteten Impulsfolgen kann ein Nutzsignal auch unter ungünstigen Umständen identifiziert werden, so dass auch grössere Distanzen oder verrauschte bzw. mit Störungen behaftete Hintergrundszenarien bewältigt werden können.

Eine der einfachsten Modulationsarten ist die Kennzeichnung der einzelnen Impulse oder der Pulsfolgen per Abstandscodierung, wie z.B. beschrieben in der EP 1 832 897 B1. Diese wird beispielsweise zu dem Zwecke der Re-Identifizierbarkeit eingesetzt. Diese Wiedererkennung ist dann erforderlich, wenn eine Mehrdeutigkeit entsteht, welche bei der Laufzeitmessung von Impulsen durch unterschiedliche Situationen hervorgerufen werden kann, beispielsweise wenn sich zwischen Vermessungsgerät und Zielobjekt mehr als ein Impuls oder eine Impulsgruppe befindet.

Bei schnellen Analog-Digital-Wandlern (ADC) wird die hohe Abtastrate in Verbindung mit einer hohen Auflösung der Signalamplitude (z.B. 1GS/s, 14bit) beispielsweise erreicht durch die Erzeugung mehrerer ADC-Wandlungsstufen, beispielsweise durch:
- ein zeitliches Verschachteln ("interleave") mehrerer langsamer ADC-Kerne,
- ein stufenweises Quantisieren der abgestasteten Signalamplituden ("pipeline"), oder
- kombiniert ein mehrstufiges Quantisieren der Signalabtastwerte von mehreren ADC-Kernen.

Bei diesen Architekturen entstehen trotz sorgfältiger interner Korrekturen architekturtypische Fehler. Diese Fehler variieren über Zeit und Temperatur.

Bei interleaved ADC wirken sich die typischen Fehler insbesondere aus als:
- Skew (Timing-Fehler zwischen den Sample-Zeitpunkten der unterschiedlichen ADC-Kerne oder ADCs)
- Gain (unterschiedlicher Verstärkungsfaktor zwischen den internen ADC-Kernbausteinen. Das Signal wird meist verstärkt und/oder gepuffert im ADC)
- Offset (unterschiedliche DC Level der internen Ausgänge der ADC Kerne)

Insbesondere bei pipelined ADCs wirken sich die typischen Fehler meist als Differentielle Nichtlinearität DNL und Integrale Nichtlinearität INL aus. DNL und INL sind Fehler bei der Umwandlung der analogen Signalwerte in digitale (ganzzahlige) Werte, beispielsweise hervorgerufen durch das stufenweise Quantisieren bei einem Pipeline-ADC in immer feiner werdende Schritte/immer grösser werdende Auflösung.

Der INL-Fehler ist im Wesentlichen die Teilsumme aller Beiträge der unter dem zu wandelnden Signalpegel liegenden DNL-Fehler und kann mehrere LSB ("Least Significant Bit") erreichen. Besonders der INL-Fehler hat deshalb bereits bei mässigen Schwankungen der Signalwerte gravierende Auswirkungen auf die digitalisierte Signalformgenauigkeit.

Die digitalisierte Signalform entspricht nicht mehr der ursprünglichen analogen Signalform. Durch interne Korrekturen im ADC-Bauteil können diese DNL- und INL-Fehler teilweise minimiert, jedoch nicht eliminiert, werden und eine externe Kalibration, welche durch Messen und Aufzeichnen des Restfehlers bewerkstelligt werden kann, ist zeitlich variabel und beispielsweise stark temperaturabhängig.

Bei der Distanzmessung entstehen durch den INL-Fehler über Distanz ein periodischer Distanzfehler im Abstand des Abtast-/Samplerasters. Des Weiteren erzeugt ein INL-Fehler einen vom Empfangssignalwert abhängigen Distanzfehler. Die Flanken eines digitalen Signalpulses sind durch die Quantisierungsfehler in der Auslenkung verfälscht, wodurch die Position des Signalpulses zur Zeitachse verschoben sein kann. Auch bei Distanzmesssystemen mit Start- und Stopp-Impulsen oder Start- und Stopp-Signalfolgen können Fehler bei der Messdistanz auftreten. Zum Beispiel ist dies dann der Fall, wenn der Startpuls eine Amplitude im mittleren Aussteuerbereich hat, wohingegen der Stopppuls eine Amplitude im unteren Amplitudenbereich hat, wobei durch eine INL-bedingte Formverzerrung beide Pulse unterschiedlich deformiert und die Absolutdistanz verfälscht wird. 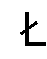 Lukasz Malkiewicz "Improvement of intelligent cyclic ADC resolution by randomization of DAC INL errors." Photonics Applications in Astronomy, Communications, Industry, and High-Energy Physics Experiments(2012): 84540Z. beschreibt die Verbesserung des INL-Fehlers in ADCs durch ein additives Zufallseingangssignal.

Es ist deshalb eine Aufgabe der Erfindung, eine verbesserte Distanzmessung mit einer gleichzeitig hohen Messgenauigkeit und einer hohen Distanzauflösung bereitzustellen.

Eine spezielle Aufgabe der Erfindung liegt dabei darin, eine verbesserte Methode und ein verbessertes System für die Signal-Digitalisierung zur Verfügung zu stellen.

Eine weitere spezielle Aufgabe der Erfindung liegt zudem darin, eine verbesserte Kompensation des INL-Fehlers bei der Signal-Digitalisierung bereitzustellen.

Diese Aufgaben werden durch die unabhängigen Ansprüche gelöst. Merkmale, die die Erfindung in alternativer oder vorteilhafter Weise weiterbilden, sind den abhängigen Patentansprüchen zu entnehmen.

Die Erfindung betrifft eine Distanzmessmethode, insbesondere für ein Laser-Distanzmessgerät, im Speziellen ausgebildet als Lasertracker, Tachymeter, Laserscanner, oder Profiler, zur Bestimmung einer Distanz zu einem Zielobjekt mit einem Aussenden von gepulsten Sendesignalen als Sendesignalreihe; einem Empfangen von zumindest Teilen der am Zielobjekt reflektierten Sendesignale der Sendesignalreihe als Empfangssignale einer Empfangssignalreihe; einem Überlagern der die Empfangssignalreihe mit einem definiert variierenden Biassignal überlagert wird, wodurch eine ADC-Eingangssignalreihe erzeugt wird, wobei der Wert des Biassignals zeitlich derart variiert wird, dass Empfangssignale der Empfangssignalreihe mit unterschiedlichen Offsetwerten innerhalb eines definierten Wertebereichs überlagert werden, insbesondere wobei das Biassignal über den von der Empfangssignalreihe beanspruchten Zeitraum mittelwertfrei ist; einem Digitalisieren der Empfangssignale der ADC-Eingangssignalreihe in Digitalsignale einer Digitalsignalreihe mittels eines Analog-Digital-Wandlers, nachfolgend ADC genannt, insbesondere vom Typ Interleave-ADC oder Pipeline-ADC; und einem Verarbeiten der Digitalsignalreihe, nämlich ein Aufsummieren oder eine Mittelung der Digitalsignale über die Digitalsignalreihe, um daraus die Distanz zum Zielobjekt abzuleiten; wobei die Bestimmung der Distanz auf dem Pulslaufzeitverfahren basiert.

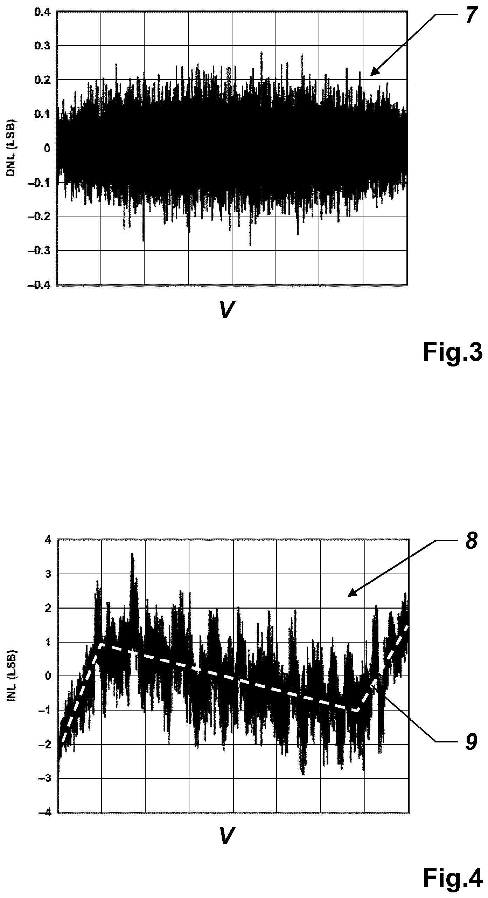

Der lineare Anteil des globalen Verlaufs eines Fehlers aufgrund einer Integralen Nichtlinearität des ADC, nachfolgend INL-Fehler genannt, in Abhängigkeit vom Signalwert eines ADC-Eingangssignals (INL-Trendverlauf, z.B. typischerweise eine "S-Form", siehe Fig. 4) erzeugt im Wesentlichen nur einen Signalverstärkungsfehler und hat keinen Einfluss auf die Distanzmessgenauigkeit. Der INL-Fehler kann hingegen lokal mit der ADC-Abtastfolge sehr stark variieren, wodurch ein Distanzmessfehler entsteht, der beispielsweise einfach periodisch oder mehrfachperiodisch ist mit der ADC-Abtastfolge.

Durch den variierenden Wert des Biassignals werden das eigentliche ADC-Messsignal und somit einzelne Empfangssignale über einen weiten Wertebereich geschoben, wodurch verschiedene(lokale) Fehlerzonen des INL-Fehlers überstrichen werden. Durch die Verarbeitung mehrerer Empfangssignale (z.B. einzelne Pulssignale, "Einzelschüsse"), beispielsweise eine Mittelung oder ein Aufsummieren, entsteht so automatisch eine Mittelung über unterschiedliche INL-Fehlerbeiträge wodurch der (lokale) INL-Fehler im verarbeiteten digitalisierten Signal minimiert wird.

Im speziellen Fall wobei das Biassignal über den von der Empfangssignalreihe beanspruchten Zeitraum mittelwertfrei ist, wird der lokale INL-Fehler minimiert, da sowohl Start-Impuls als auch der Stopp-Impuls über wesentliche lokale INL-bedingte Formverzerrungen erfasst und gemittelt werden.

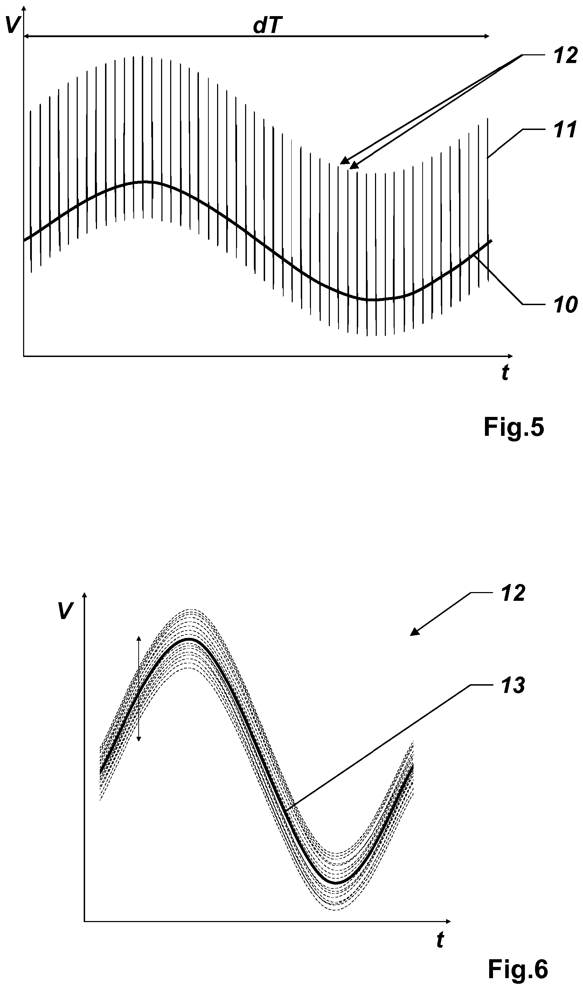

Der Fehler der schlussendlich gemessenen Absolutdistanz ist dadurch minimiert. Im Falle eines allgemeinen, nicht mittelwertfreien, variablen Biassignals wird dagegen ein im Wesentlichen konstanter Offset entlang der Amplituden-Richtung einer INL-Fehlerkurve (siehe Fig. 5) eingeführt, welcher aber im Rahmen der Kalibration des globalen INL-Fehlers berücksichtigt werden kann.

Insbesondere werden in einer speziellen Ausführungsform die unterschiedlichen Offsetwerte beim Verarbeiten der Digitalsignalreihe berücksichtigt um eine mittlere Integrale Nichtlinearität des ADC als Funktion eines Signalwerts eines ADC-Eingangssignals zu kompensieren.

Im Speziellen ist das Biassignal ausgestaltet als ein Signal mit einer niederfrequenten Schwingungskomponente (beispielsweise mit einer Frequenz < 1 MHz), insbesondere ein Sinussignal, ein Sägezahnsignal, ein Treppensignal, ein Dreiecksignal, oder ein Trapezsignal.

In einer weiteren Ausführungsform wird das Biassignal durch mindestens eine der folgenden Massnahmen erzeugt: ein Hinzufügen von unterschiedlichen diskreten DC-Werten zu einem ADC-Eingangssignal einer durch die Empfangssignalreihe erzeugten ADC-Eingangssignalreihe an unterschiedlichen Zeitpunkten der ADC-Eingangssignalreihe, insbesondere eingestellt durch einen Digital-Analog-Wandler, nachfolgend DAC genannt; ein periodisches Verschieben der Offsetpegel der Gleichtaktspannung des ADC; und einen Rauschgenerator zur Erzeugung eines variablen Zusatzsignals zur ADC-Eingangssignalreihe, insbesondere durch Ausnutzung des thermischen Rauschens von Widerständen, Dioden oder ähnlichem oder durch Überlagerung einer Pseudo-Zufallsfolge erzeugt durch rückgekoppelte Schieberegister.

Der mittlere (lokale) INL-Fehler kann beispielsweise als Funktion eines mittleren Signalwerts über unterschiedliche Wertebereiche variieren, z.B. in dem Sinne, dass der (lokale) INL-Fehler beispielsweise für einen Bereich mit einem höheren mittleren Signalwert grösser ist als für einen Bereich mit niedrigerem mittleren Signalwert. Des Weiteren hängt die Minimierung des lokalen INL-Fehlers, also auch die erreichte Distanzmessgenauigkeit, entscheidend vom Wertebereich ab, über den das eigentliche Messsignal variiert (und somit gemittelt) wird.

Eine spezielle Ausführungsform betrifft eine Einstellung des Wertebereichs des Biassignals, insbesondere mit einem FPGA oder einem Mikroprozessor, basierend auf einer definierten Messgenauigkeit für die Bestimmung der Distanz, und/oder eines gemessenen Werts eines Empfangssignals.

### ERSATZSEITE - REINSCHRIFT

Die Erfindung betrifft weiter ein elektronisches Laserdistanzmessmodul, insbesondere zur Verwendung in einem Distanzmessgerät, im Speziellen ausgebildet als Lasertracker, Tachymeter, Laserscanner, oder Profiler, für eine Bestimmung einer Distanz zu einem Zielobjekt mit einem Sendekanal mit einer Sendeeinheit zur Erzeugung von optischen Sendesignalen einer Sendesignalreihe, mittels gepulster Lasermessstrahlung; einem Empfangskanal mit einer Empfangseinheit zum Empfang von zumindest Teilen der am Zielobjekt reflektierten Sendesignale der Sendesignalreihe als Empfangssignale einer Empfangssignalreihe; wobei das Laserdistanzmessmodul derart ausgebildet ist, dass ein definiert variierendes Biassignal erzeugt wird, und die Empfangssignalreihe mit dem Biassignal überlagert wird, wodurch eine ADC-Eingangssignalreihe erzeugt wird, wobei der Wert des Biassignals zeitlich derart variiert wird, dass Empfangssignale der Empfangssignalreihe mit unterschiedlichen Offsetwerten innerhalb eines definierten Wertebereichs überlagert werden, insbesondere wobei das Biassignal über den von der Empfangssignalreihe beanspruchten Zeitraum mittelwertfrei ist, einer Empfangsschaltung für eine Digitalisierung der ADC-Eingangssignalreihe in Digitalsignale einer Digitalsignalreihe mit einem Analog-Digital-Wandler, nachfolgend ADC genannt, insbesondere vom Typ Interleave-ADC oder Pipeline-ADC; und einer Kontroll- und Steuereinheit für eine Bestimmung der Distanz zum Zielobjekt basierend auf einer Verarbeitung der Digitalsignalreihe, nämlich ein Aufsummieren oder eine Mittelung der Digitalsignale über die Digitalsignalreihe; wobei die Bestimmung der Distanz auf dem Pulslaufzeitverfahren basiert.

Das Laserdistanzmessmodul ist dabei gemäss der vorliegenden Erfindung derart angepasst, dass ein definiert variierendes Biassignal erzeugt wird und die Empfangssignalreihe mit dem Biassignal überlagert wird, wobei der Wert des Biassignals zeitlich derart variiert wird, dass Empfangssignale der Empfangssignalreihe mit unterschiedlichen Offsetwerten innerhalb eines definierten Wertebereichs überlagert werden, insbesondere wobei das Biassignal über den von der Empfangssignalreihe beanspruchten Zeitraum mittelwertfrei ist.

In einer speziellen Ausführungsform ist das Laserdistanzmessmodul derart ausgestaltet, dass die unterschiedlichen Offsetwerte beim Verarbeiten der Digitalsignalreihe durch die Kontroll- und Steuereinheit berücksichtigt werden um eine mittlere Integrale Nichtlinearität des ADC als Funktion eines Signalwerts eines ADC-Eingangssignals zu kompensieren.

In einer weiteren Ausführungsform des erfindungsgemässen Laserdistanzmessmoduls ist das Biassignal ausgestaltet als ein Signal mit einer niederfrequenten Schwingungskomponente (z.B. mit einer Schwingungsfrequenz < 1MHz), insbesondere ein Sinussignal, ein Sägezahnsignal, ein Treppensignal, ein Dreiecksignal, oder ein Trapezsignal.

Das Biassignal kann dabei beispielsweise durch mindestens eine der folgenden Massnahmen erzeugt werden: ein Hinzufügen von unterschiedlichen diskreten DC-Werten zu einem ADC-Eingangssignal einer durch die Empfangssignalreihe erzeugten ADC-Eingangssignalreihe an unterschiedlichen Zeitpunkten der ADC-Eingangssignalreihe, insbesondere eingestellt durch einen Digital-Analog-Wandler, nachfolgend DAC genannt; ein periodisches Verschieben der Offsetpegel der Gleichtaktspannung des ADC; und einen Rauschgenerator zur Erzeugung eines variablen Zusatzsignals zur ADC-Eingangssignalreihe, insbesondere durch Ausnutzung des thermischen Rauschens von Widerständen, Dioden oder ähnlichem oder durch Überlagerung einer Pseudo-Zufallsfolge erzeugt durch rückgekoppelte Schieberegister.

In einer vorteilhaften Ausführungsform ist das erfindungsgemässe Laserdistanzmessmodul derart angepasst, dass der Wertebereich des Biassignals eingestellt wird, insbesondere mit einem FPGA oder einem Mikroprozessor, basierend auf einer definierten Messgenauigkeit für die Bestimmung der Distanz und/oder eines gemessenen Werts eines Empfangssignals.

### ERSATZSEITE - REINSCHRIFT

Die erfindungsgemässe Distanzmessmethode und das erfindungsgemässe Laserdistanzmessmodul werden nachfolgend anhand von in den Zeichnungen schematisch dargestellten Ausführungsbeispielen rein beispielhaft näher beschrieben. Gleiche Elemente sind in den Figuren mit gleichen Bezugszeichen gekennzeichnet. Die beschriebenen Ausführungsformen sind in der Regel nicht massstabsgetreu dargestellt und sie sind auch nicht als Einschränkung zu verstehen.

Im Einzelnen zeigen
- Fig. 1a,b:: schematische Illustration des Pulslaufzeitverfahrens in einem elektrooptischen Distanzmessgerät nach dem Stand der Technik;
- Fig. 2a,b:: Prinzipiendarstellung einer Digitalisierung durch einen Analog-Digital-Wandler (ADC) mit einem linearen Zusammenhang zwischen dem ADC-Eingangssignal und den digitalisierten Ausgangswerten (a) und mit einer Differentiellen Nichtlinearität (b);
- Fig. 3:: typische Fehlerkurve für eine Differentielle Nichtlinearität eines ADC;
- Fig. 4:: typische Fehlerkurve für eine Integrale Nichtlinearität eines schnellen ADC;
- Fig. 5:: Illustration einer Kompensation des INL-Fehlers mittels einer Überlagerung des durch die detektierten Empfangssignale erzeugten Messsignals mit einem variierenden Biassignal;
- Fig. 6:: Illustration einer Mittelung über mehrere Empfangssignale, welche für die Erzeugung des ADC-Eingangssignals erfindungsgemäss mit einem variierenden Biassignal überlagert wurden;
- Fig. 7:: beispielhafte Ausführungsform eines Empfangskanals eines erfindungsgemässen Laserdistanzmessmoduls.

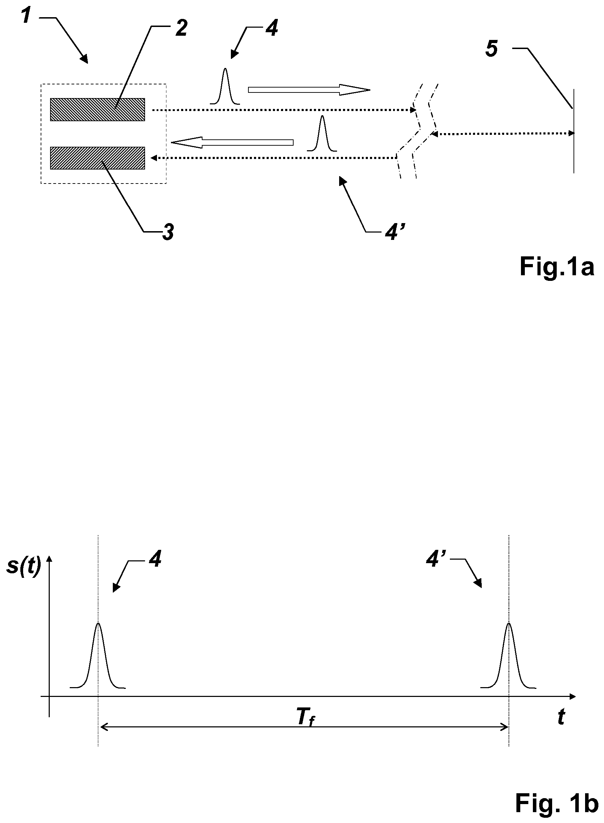

Die Figuren 1a und 1b illustrieren das Pulslaufzeitprinzip wie es in typischen elektro-optischen Distanzmessgeräten nach dem Stand der Technik verwendet wird.

**Figur 1a** zeigt eine Prinzipdarstellung eines elektrooptischen Distanzmessers 1 des Stands der Technik nach dem Pulslaufzeitprinzip. In dem Distanzmesser 1 sind ein Sender 2 und ein Empfänger 3 angeordnet. Der Sender 2 emittiert einen Lichtpuls 4, der nach der Reflektion bzw. Rückstreuung an einem Ziel, z.B. einem kooperativen Zielobjekt wie ein Retroreflektor 5 oder einem unkooperativen Zielobjekt wie eine natürliche Oberfläche, wieder als zurückgestreuter Lichtpuls 4' vom Empfänger 3 detektiert wird. Anstelle der Lichtpulse wird oft auch ein kontinuierlich moduliertes Sendesignal verwendet.

Wie in **Figur 1b** schematisch erläutert, wird die Entfernung aus der Laufzeit T_{f} als zeitliche Differenz zwischen dem Startzeitpunkt des Aussendens eines Lichtpulses 4 und dem Empfangszeitpunkt des zurückgestreuten Lichtpulses 4' ermittelt. Die Ermittlung des Empfangszeitpunktes erfolgt dabei durch die Auswertung eines Merkmals des Signalimpulses s(t), z.B. durch das Überschreiten einer Signalschwelle oder - wie in der vorliegenden Erfindung - durch Abtastung des Signalimpulses, wobei nach Identifikation der Codierung des zugehörigen Sendesignals eines empfangenen Signals aus einem definierten Verlaufspunkt des abgetasteten und digitalisierten Signals, beispielsweise den Wendepunkten, den Kurvenmaxima, oder integral mittels eines aus der Zeitinterpolation bekannten Optimum Filters, sehr genau eine Pulslaufzeit bestimmt wird. Eine weitere Methode für die Bestimmung eines definierten Verlaufspunkts umfasst z.B. auch eine Umwandlung des Empfangssignals in ein bipolares Signal und eine anschliessende Bestimmung des Nulldurchgangs.

Bei der zeitlich präzisen Abtastung des zurückgestreuten Pulses wird das vom Detektor erzeugte elektrische Signal mittels eines Analog-Digital-Wandlers ("Analog-Digital-Converter", ADC) in eine digitale Signalfolge umgewandelt, welches anschliessend meistens in Echtzeit weiter verarbeitet wird. Durch die Verwendung einer Vielzahl von Abtastfolgen und/oder zur Emissionsrate synchronem Aufsummieren des Empfangssignals kann ein Nutzsignal auch unter ungünstigen Umständen identifiziert werden, so dass auch grössere Distanzen oder verrauschte bzw. mit Störungen behaftete Hintergrundszenarien bewältigt werden können.

Bei schnellen Analog-Digital-Wandlern (ADC) wird die hohe Abtastrate in Verbindung mit einer hohen Auflösung des Signalwerts beispielsweise erreicht durch ein zeitliches Verschachteln ("interleave") mehrerer langsamer ADCs, und/oder durch ein stufenweises Quantisieren ("pipeline"). Dabei entstehen trotz sorgfältiger interner Korrekturen architekturtypische Fehler, welche über Zeit und beispielsweise Temperatur variieren.

Insbesondere bei Pipeline-ADC wirken sich die typischen Fehler meist als Differentielle Nichtlinearität DNL und Integrale Nichtlinearität INL aus. DNL und INL sind Fehler bei der Umwandlung des analogen Signalwerts in digitale (ganzzahlige) Werte, beispielsweise hervorgerufen durch das stufenweise Quantisieren bei einem Pipeline-ADC in immer feiner werdende Schritte/immer grösser werdende Auflösung.

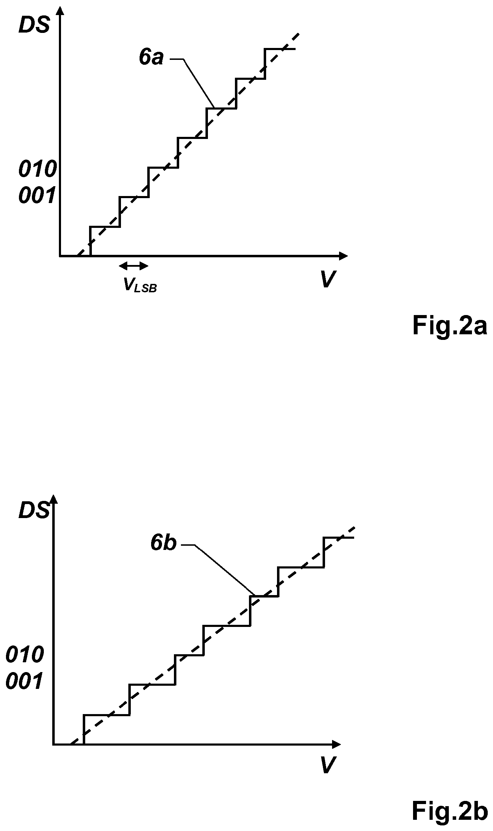

Die Figuren 2a und 2b illustrieren den Effekt einer Differentiellen Nichtlinearität DNL bei einer Digitalisierung durch einen Analog-Digital-Wandler (ADC). Die Figuren zeigen jeweils einen Plot für das erzeugte digitale Signal DS als Funktion der Spannung V eines analogen ADC-Eingangssignals.

**Figur 2a** illustriert den Idealfall, wobei die Digitalisierung derart erfolgt, dass die Differenz der Schwellspannung zum nächsten Digitalwert konstant ist, d.h. dass eine lineare Digitalisierung mit einer Digitalisierungs-Stufenfunktion 6a erzeugt wird, deren Stufenbreite V_{LSB} konstant ist. Jeweils zwei benachbarte digitale Werte, z.B. die digitalen Werte 001 und 010, entsprechen damit zwei umgesetzten analogen Eingangsspannungen, welche genau eine Sollspannung V_{LSB} ("Least Significant Bit") auseinander liegen.

Im Gegensatz dazu zeigt **Figur 2b** den Effekt einer Differentiellen Nichtlinearität DNL, wobei nun jeweils benachbarte digitale Werte, beispielsweise die digitalen Werte 001 und 010, analogen Eingansspannungen entsprechen, deren Spannungsdifferenz kleiner oder grösser als die Sollspannung V_{LSB} sind. Dies ergibt eine nichtlineare Digitalisierung mit einer Digitalisierungs-Stufenfunktion 6b mit unterschiedlicher Stufenbreite.

Der INL-Fehler ist im Wesentlichen die Summe aller DNL-Fehler aufsummiert bis zum Spannungswert V des Eingangssignals und kann mehrere LSB erreichen. Besonders der INL-Fehler hat deshalb bereits bei mässigen Schwankungen des Signalwerts gravierende Auswirkungen auf die digitalisierte Signalformgenauigkeit und bei der Distanzmessung entstehen durch den INL-Fehler über Distanz beispielsweise ein einfach periodischer Distanzfehler im Abstand des Abtastrasters.

**Figur 3** zeigt eine typische Fehlerkurve 7 für eine Differentielle Nichtlinearität DNL, beispielsweise eines einzelnen ADC einer Interleave-ADC Architektur oder einer Quantisierungsstufe eines Pipeline-ADC. Die DNL-Fehlerkurve 7 zeigt als Funktion der Eingangsspannung V die Abweichung benachbarter digitalisierter Werte vom idealen Sollwert von jeweils einer LSB-Stufe ("Least Significant Bit").

**Figur 4** zeigt eine typische Fehlerkurve 8 für eine Integrale Nichtlinearität INL, beispielweise einer schnellen Interleave-ADC Architektur oder eines Pipeline-ADC. Die INL-Fehlerkurve 8 zeigt als Funktion der ADC-Eingangsspannung V die Abweichung des digitalisierten Wertes vom idealen Sollwert ausgedrückt in LSB-Einheiten.

Der globale Verlauf der INL-Fehlerkurve 8 (typischerweise eine S-Form) ist hier der Einfachheit halber dargestellt durch eine Zickzack-Linie 9 mit drei unterschiedlichen Steigungen. Bleiben die abgetasteten Spannungswerte eines Empfangssignals innerhalb eines INL-Bereichs mit einem im Wesentlichen linearen Steigungswert, dann erzeugt dies eine amplitudenabhängige Signalverstärkung, was zu einer Verzerrung der Pulsform führt und die Distanzmessgenauigkeit reduziert. Umfasst die abgetastete Signalform grössere Abweichungen von einem mittleren, linearen Steigungsbereich der INL-Kurve (die Signalform umfasst z.B. einen "Knick" der Zickzack-Linie 9), dann entstehen weitere Verzerrungen an der Signalform und die Genauigkeit einer Distanzmessung zeigt zum Abtastraster zyklische Fehler. Dieselben Ueberlegungen gelten auch für den Start-Impuls. Die minimale Auslenkung des variierenden Biassignals sollte daher ausreichend gross gewählt werden, sodass beispielsweise die den Start- und Stopp-Impulsen zugeordneten Abtastwerte im Mittel je einen linearen Steigungsbereich der INL-Kurve überstreichen.

Eine lokale Krümmung der INL-Fehlerkurve 8 (die lokalen Ausschläge/Abweichungen der INL-Fehlerkurve 8 vom globalen Verlauf 9) erzeugt einen Distanzmessfehler der beispielsweise zumindest einfach periodisch ist zum Abtastraster. Diese lokalen Ausschläge der INL-Kurve beeinflussen die Distanzmessgenauigkeit erheblich. Die lokale Krümmung der INL-Fehlerkurve und der dadurch entstehende Distanzmessfehler werden durch die Merkmale der vorliegenden Erfindung korrigiert.

**Figur 5** illustriert die Korrektur des INL-Fehlers (der lokalen Krümmung der INL-Fehlerkurve 8, siehe Fig. 4) mittels einer Überlagerung des durch die detektierten Empfangssignale erzeugten Messsignals mit einem variierenden Biassignal 10.

Die Figur zeigt eine erfindungsgemäss erzeugte ADC-Eingangssignalreihe 11 (Empfangssignalreihe) als Funktion der Zeit t, bestehend aus einer Überlagerung des durch mehrere (gepulste) Empfangssignale 12 ("Einzelschüsse") einer Empfangssignalreihe erzeugten eigentlichen Messsignals mit dem variierenden Biassignal 10, hier beispielsweise ein niederfrequentes Sinus-Signal, wobei hier das überlagerte Biassignal 10 über den von der ADC-Eingangssignalreihe beanspruchten Zeitraum dT mittelwertfrei ist.

Das Biassignal 10 kann insbesondere ein niederfrequentes Schwingungssignal sein, beispielsweise ein Sinus-, Sägezahn-, Stufen-, Dreieck-, oder Trapezförmiges Signal, wobei das Biassignal 10 zum Beispiel erzeugt werden kann durch ein Hinzufügen von diskreten DC-Werten zum eigentlich erzeugten Messsignal, z.B. eingestellt durch einen Digital-Analog-Wandler (DAC).

**Figur 6** illustriert eine Mittelung über mehrere Empfangssignale 12 ("Einzelschüsse") einer Empfangssignalreihe, welche für die Erzeugung der ADC-Eingangssignalreihe 11 (siehe Fig.5) erfindungsgemäss mit einem variierenden Biassignal 10 (siehe Fig. 5) überlagert wurde.

Durch die Überlagerung mit dem Biassignal 10 wird das eigentliche Messsignal eines Empfangssignals 13 bei der Mittelung, in einer speziellen Ausführungsform mittelwertfrei, über einen weiten Wertebereich geschoben, wodurch verschiedene Fehlerzonen der INL-Fehlerkurve 8 (siehe Fig. 4) überstrichen werden. Durch Mittelung über mehrere Empfangssignale entsteht somit eine Mittelung über unterschiedliche INL-Fehlerbeiträge, wodurch der INL-Fehlereinfluss signifikant reduziert wird, insbesondere ohne eine Verschlechterung des Signal-Rausch-Verhältnisses (SNR). Eine besonders effiziente Beseitigung des INL-Einflusses auf die Signalform und damit auf die Distanzmessung wird erreicht, wenn die Schussfolgefrequenz asynchron zum Abtastraster und asynchron zum Biassignal erfolgt.

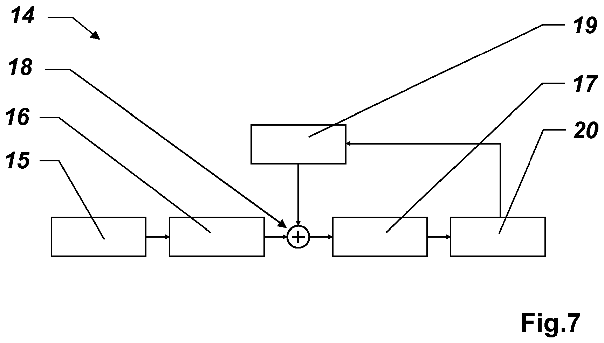

**Figur 7** zeigt eine beispielhafte Ausführungsform eines Empfangskanals 14 eines erfindungsgemässen Laserdistanzmessmoduls mit einer Empfangsoptik und einer Empfangseinheit 15 zum Empfangen von an einem Zielobjekt reflektierten Sendesignalen als Empfangssignale, einer Anlagenelektronik 16 zur Aufbereitung der Empfangssignale in ein analoges elektrisches Messsignal, sowie einen (schnellen) Analog-Digital-Wandler (ADC) 17, beispielsweise mit Interleave-Architektur oder Pipeline-Architektur.

Das Biassignal 10 (siehe Fig. 5) wird der ADC-Eingangssignalreihe überlagert 18, beispielsweise durch ein Hinzufügen von diskreten DC-Werten zum eigentlich erzeugten Messsignal, z.B. eingestellt durch einen Digital-Analog-Wandler (DAC) 19.

Durch die zeitliche Variation des INL Fehlers, beispielsweise temperaturbedingt, durch unterschiedliche Anforderungen an die Messgenauigkeit und durch unterschiedliche Empfangsstärken, kann gegebenenfalls die Amplitude des variierenden Biassignals 10 variiert werden, z.B. mit einem FPGA oder Mikroprozessor 20, welcher das ADC Signal aufzeichnet und verarbeitet.

Es versteht sich, dass diese dargestellten Figuren nur mögliche Ausführungsbeispiele schematisch darstellen. Die verschiedenen Ansätze können ebenso miteinander sowie mit Verfahren des Stands der Technik kombiniert werden.

## Patentansprüche

1. Distanzmessmethode, insbesondere für ein Laser-Distanzmessgerät, im Speziellen ausgebildet als Lasertracker, Tachymeter, Laserscanner, oder Profiler, zur Bestimmung einer Distanz zu einem Zielobjekt mit
• einem Aussenden von gepulsten Sendesignalen als Sendesignalreihe,
• einem Empfangen von zumindest Teilen der am Zielobjekt reflektierten Sendesignale der Sendesignalreihe als Empfangssignale (12) einer Empfangssignalreihe,
• einem Überlagern der Empfangssignalreihe mit einem definiert variierenden Biassignal (10), wodurch eine ADC-Eingangssignalreihe erzeugt wird, wobei der Wert des Biassignals (10) zeitlich derart variiert wird, dass Empfangssignale (12) der Empfangssignalreihe mit unterschiedlichen Offsetwerten innerhalb eines definierten Wertebereichs überlagert werden,
insbesondere wobei das Biassignal (10) über den von der Empfangssignalreihe beanspruchten Zeitraum mittelwertfrei ist,
• einem Digitalisieren der ADC-Eingangssignalreihe in Digitalsignale einer Digitalsignalreihe mittels eines Analog-Digital-Wandlers (17), nachfolgend ADC genannt, insbesondere vom Typ Interleave-ADC oder Pipeline-ADC, und
• einem Verarbeiten der Digitalsignalreihe, nämlich ein Aufsummieren oder eine Mittelung der Digitalsignale über die Digitalsignalreihe, um daraus die Distanz zum Zielobjekt abzuleiten, wobei die Bestimmung der Distanz auf dem Pulslaufzeitverfahren basiert.

2. Distanzmessmethode nach Anspruch 1,
**dadurch gekennzeichnet, dass**
die unterschiedlichen Offsetwerte beim Verarbeiten der Digitalsignalreihe berücksichtigt werden um eine mittlere Integrale Nichtlinearität (8) des ADC als Funktion eines Signalwerts eines ADC-Eingangssignals (11) zu kompensieren.

3. Distanzmessmethode nach Anspruch 1 oder 2,
**dadurch gekennzeichnet, dass**
das Biassignal (10) ausgestaltet ist als ein Signal mit einer niederfrequenten Schwingungskomponente, insbesondere ein Sinussignal, ein Sägezahnsignal, ein Treppensignal, ein Dreiecksignal, oder ein Trapezsignal.

4. Distanzmessmethode nach einem der vorangehenden Ansprüche,
**dadurch gekennzeichnet, dass**
das Biassignal (10) durch mindestens eine der folgenden Massnahmen erzeugt wird
• ein Hinzufügen von unterschiedlichen diskreten DC-Werten zu einem eigentlich durch die Empfangssignalreihe erzeugten Messsignal an unterschiedlichen Zeitpunkten des eigentlich erzeugten Messsignals, insbesondere eingestellt durch einen Digital-Analog-Wandler (19), nachfolgend DAC genannt,
• ein periodisches Verschieben der Offsetpegel der Gleichtaktspannung des ADC (17), und
• einen Rauschgenerator zur Erzeugung eines variablen Zusatzsignals zum eigentlich erzeugten Messsignal.

5. Distanzmessmethode nach einem der vorhergehenden Ansprüche,
**dadurch gekennzeichnet, dass**
der Wertebereich des Biassignals (10) eingestellt wird, insbesondere mit einem FPGA oder einem Mikroprozessor (20), basierend auf
• einer definierten Messgenauigkeit für die Bestimmung der Distanz, und/oder
• eines gemessenen Signalwerts eines Empfangssignals (12).

6. Elektronisches Laserdistanzmessmodul, insbesondere zur Verwendung in einem Distanzmessgerät, im Speziellen ausgebildet als Lasertracker, Tachymeter, Laserscanner, oder Profiler, für eine Bestimmung einer Distanz zu einem Zielobjekt mit
• einem Sendekanal mit einer Sendeeinheit zur Erzeugung von Sendesignalen einer Sendesignalreihe mittels gepulster Lasermessstrahlung,
• einem Empfangskanal (14) mit einer Empfangseinheit (15) zum Empfang von zumindest Teilen der am Zielobjekt reflektierten Sendesignale der Sendesignalreihe als Empfangssignale (12) einer Empfangssignalreihe,
wobei das Laserdistanzmessmodul derart ausgebildet ist, dass
• ein definiert variierendes Biassignal (10) erzeugt wird, und
• die Empfangssignalreihe mit dem Biassignal (10) überlagert wird, wodurch eine ADC-Eingangssignalreihe erzeugt wird,
wobei der Wert des Biassignals (10) zeitlich derart variiert wird, dass Empfangssignale (12) der Empfangssignalreihe mit unterschiedlichen Offsetwerten innerhalb eines definierten Wertebereichs überlagert werden,
insbesondere wobei das Biassignal (10) über den von der Empfangssignalreihe beanspruchten Zeitraum mittelwertfrei ist,
wobei das Laserdistanzmessmodul weiter aufweist
• eine Empfangsschaltung für eine Digitalisierung der ADC-Eingangssignalreihe in Digitalsignale einer Digitalsignalreihe mit einem Analog-Digital-Wandler (17), nachfolgend ADC genannt, insbesondere vom Typ Interleave-ADC oder Pipeline-ADC, und
• eine Kontroll- und Steuereinheit für eine Bestimmung der Distanz zum Zielobjekt basierend auf einer Verarbeitung der Digitalsignalreihe, nämlich ein Aufsummieren oder eine Mittelung der Digitalsignale über die Digitalsignalreihe, wobei die Bestimmung der Distanz auf dem Pulslaufzeitverfahren basiert.

7. Laserdistanzmessmodul nach Anspruch 6,
**dadurch gekennzeichnet, dass**
die unterschiedlichen Offsetwerte beim Verarbeiten der Digitalsignalreihe durch die Kontroll- und Steuereinheit berücksichtigt werden um eine mittlere Integrale Nichtlinearität (8) des ADC als Funktion eines Signalwerts eines ADC-Eingangssignals (11) zu kompensieren.

8. Laserdistanzmessmodul nach Anspruch 6 oder 7,
**dadurch gekennzeichnet, dass**
das Biassignal (10) ausgestaltet ist als ein Signal mit einer niederfrequenten Schwingungskomponente, insbesondere ein Sinussignal, ein Sägezahnsignal, ein Treppensignal, ein Dreiecksignal, oder ein Trapezsignal.

9. Laserdistanzmessmodul nach einem der Ansprüche 6 bis 8, **dadurch gekennzeichnet, dass**
das Biassignal (10) durch mindestens eine der folgenden Massnahmen erzeugt wird
• ein Hinzufügen von unterschiedlichen diskreten DC-Werten zu einem eigentlich durch die Empfangssignalreihe erzeugten Messsignal an unterschiedlichen Zeitpunkten des eigentlich erzeugten Messsignals, insbesondere eingestellt durch einen Digital-Analog-Wandler (19), nachfolgend DAC genannt,
• ein periodisches Verschieben der Offsetpegel der Gleichtaktspannung des ADC (17), und
• einen Rauschgenerator zur Erzeugung eines variablen Zusatzsignals zum eigentlich erzeugten Messsignal.

10. Laserdistanzmessmodul nach einem der Ansprüche 6 bis 9, **dadurch gekennzeichnet, dass**
der Wertebereich des Biassignals (10) eingestellt wird, insbesondere mit einem FPGA oder einem Mikroprozessor (20), basierend auf
• einer definierten Messgenauigkeit für die Bestimmung der Distanz, und/oder
• eines gemessenen Signalwerts eines Empfangssignals (12).

11. Laserdistanzmessmodul nach einem der Ansprüche 6 bis 10,
**dadurch gekennzeichnet, dass**
das Laserdistanzmessmodul derart ausgebildet ist, dass der ADC (17) durch mindestens zwei ADC-Wandlungsstufen ein ADC-Abtastraster erzeugt, wobei
• das ADC-Abtastraster bezüglich eines Empfangssignals (12) ein initiales Signalabtastraster mit mindestens einem initialen Abtastpunkt des Empfangssignals (12) definiert, und
• die Empfangssignale (12) der Empfangssignalreihe relativ zum ADC-Abtastraster mittels einer ersten zeitlichen Verschiebung derart zeitlich verschoben werden, dass der mindestens eine initiale Abtastpunkt mindestens einmal durch eine erste ADC-Wandlungsstufe und mindestens einmal durch eine zweite ADC-Wandlungsstufe erfasst wird,
insbesondere wobei die Empfangssignale (12) der Empfangssignalreihe relativ zum ADC-Abtastraster mittels einer zweiten zeitlichen Verschiebung zusätzlich zeitlich verschoben werden, dass in einem definierten Abtastbereich um den mindestens einen initialen Abtastpunkt eine Vielzahl von sekundären jeweils um einen Bruchteil der Periodendauer des ADC-Taktes verschobenen Abtastpunkten der Empfangssignale entstehen und dadurch unterschiedliche Signalpositionen um den mindestens einen initialen Abtastpunkt mit variierendem Signalwert abgetastet werden.

## Claims

1. Distance measuring method, in particular for a laser distance measuring apparatus, especially configured as a laser tracker, tachymeter, laser scanner, or profiler, for determining a distance to a target object comprising
• emitting pulsed transmission signals, as a transmission signal series,
• receiving at least portions of the transmission signals of the transmission signal series reflected at the target object as reception signals (12) of a reception signal series,
• superimposing the reception signal series with a bias signal (10) that varies in a defined manner, whereby an ADC input signal is generated, wherein the value of the bias signal (10) is varied over time in such a way that reception signals (12) of the reception signal series are superimposed with different offset values within a defined value range
in particular wherein the bias signal (10) is average-value-free over the time period occupied by the reception signal series
• digitizing the ADC input signal into digital signals of a digital signal series by means of an analog-to-digital converter (17), referred to hereinafter as ADC, in particular of the interleave ADC or pipeline ADC type, and
• processing the digital signal series, namely summing or averaging the digital signals over the digital signal series, in order to derive the distance to the target object therefrom, wherein the determination of the distance is based on the pulse time-of-flight method.

2. Distance measuring method according to claim 1, **characterized in that**
the different offset values are taken into account during the processing of the digital signal series in order to compensate for an average integral nonlinearity (8) of the ADC as a function of a signal value of an ADC input signal (11).

3. Distance measuring method according to claim 1 or 2, **characterized in that**
the bias signal (10) is configured as a signal having a low-frequency oscillation component, in particular a sinusoidal signal, a sawtooth signal, a staircase signal, a triangular signal, or a trapezoidal signal.

4. Distance measuring method according to any one of the preceding claims,
**characterized in that**
the bias signal (10) is generated by means of at least one of the following measures:
• adding different discrete DC values to an actual measurement signal generated by the reception signal series at different instants of the actual measurement signal generated, in particular set by a digital-to-analog converter (19), referred to hereinafter as DAC,
• periodically shifting the offset levels of the common-mode voltage of the ADC (17), and
• a noise generator for generating a variable additional signal to the actual measurement signal generated.

5. Distance measuring method according to any one of the preceding claims,
**characterized in that**
the value range of the bias signal (10) is set, in particular by means of an FPGA or a microprocessor (20), on the basis of
• a defined measurement accuracy for the determination of the distance, and/or
• a measured signal value of a reception signal (12).

6. Electronic laser distance measuring module, in particular for use in a distance measuring apparatus, especially configured as a laser tracker, tachymeter, laser scanner, or profiler, for determining a distance to a target object comprising
• a transmission channel having a transmitting unit for generating transmission signals of a transmission signal series by means of pulsed laser measurement radiation,
• a reception channel (14) having a receiving unit (15) for receiving at least portions of the transmission signals of the transmission signal series reflected at the target object as reception signals (12) of a reception signal series,
wherein
the laser distance measuring module is configured in such a way that
• a bias signal (10) that varies in a defined manner is generated, and
• the reception signal series is superimposed with the bias signal (10), whereby an ADC input signal is generated,
wherein the value of the bias signal (10) is varied over time in such a way that reception signals (12) of the reception signal series are superimposed with different offset values within a defined value range, in particular wherein the bias signal (10) is average-value-free over the time period occupied by the reception signal series
wherein laser distance measuring module further comprises
• a reception circuit for digitizing the ADC input signal into digital signals of a digital signal series with an analog-to-digital converter (17), referred to as ADC hereinafter, in particular of the interleave ADC or pipeline ADC type, and
• a supervisory and control unit for determining the distance to the target object on the basis of a processing of the digital signal series, namely summing or averaging the digital signals over the digital signal series, wherein the determination of the distance is based on the pulse time-of-flight method.

7. Laser distance measuring module according to claim 6, **characterized in that**
the different offset values are taken into account during the processing of the digital signal series by the supervisory and control unit in order to compensate for an average integral nonlinearity (8) of the ADC as a function of a signal value of an ADC input signal (11).

8. Laser distance measuring module according to claim 6 or 7,
**characterized in that**
the bias signal (10) is configured as a signal having a low-frequency oscillation component, in particular a sinusoidal signal, a sawtooth signal, a staircase signal, a triangular signal, or a trapezoidal signal.

9. Laser distance measuring module according to any one of claims 6 to 8,
**characterized in that**
the bias signal (10) is generated by means of at least one of the following measures:
• adding different discrete DC values to an actual measurement signal generated by the reception signal series at different instants of the actual measurement signal generated, in particular set by a digital-to-analog converter (19), referred to hereinafter as DAC,
• periodically shifting the offset levels of the common-mode voltage of the ADC (17), and
• a noise generator for generating a variable additional signal to the actual measurement signal generated.

10. Laser distance measuring module according to any one of claims 6 to 9,
**characterized in that**
the value range of the bias signal (10) is set, in particular by means of an FPGA or a microprocessor (20), on the basis of
• a defined measurement accuracy for the determination of the distance, and/or
• a measured signal value of a reception signal (12).

11. Laser distance measuring module according to claim 6 to 10,
**characterized in that**
the laser distance measuring module is configured in such a way that the ADC (17) generates an ADC sampling pattern by means of at least two ADC conversion stages, wherein
• the ADC sampling pattern defines with respect to a reception signal (12) an initial signal sampling pattern with at least one initial sampling point of the reception signal (12), and
• the reception signals (12) of the reception signal series are temporally shifted relative to the ADC sampling pattern by means of a first temporal shift, such that the at least one initial sampling point is detected at least once by a first ADC conversion stage and at least once by a second ADC conversion stage,
in particular wherein the reception signals (12) of the reception signal series are additionally temporally shifted relative to the ADC sampling pattern by means of a second temporal shift such that in a defined sampling range around the at least one initial sampling point a multiplicity of secondary sampling points of the reception signals arise, said secondary sampling points being shifted in each case by a fraction of the period duration of the ADC clock signal, and this results in the sampling of different signal positions around the at least one initial sampling point with a varying signal value.

## Revendications

1. Procédé de mesure de distance, en particulier pour un appareil de mesure de distance par laser, en particulier réalisé sous la forme d'un laser tracker, d'un tachymètre, d'un scanner laser ou d'un profileur, pour déterminer une distance par rapport à un objet cible, comprenant :
• une émission de signaux d'émission pulsés sous la forme d'une série de signaux d'émission,
• une réception d'au moins des parties des signaux d'émission de la série de signaux d'émission réfléchis sur l'objet cible sous la forme de signaux de réception (12) d'une série de signaux de réception,
• une superposition de la série de signaux de réception avec un signal de polarisation (10) variant de manière définie, de sorte qu'une série de signaux d'entrée d'ADC est générée, la valeur du signal de polarisation (10) variant dans le temps de telle sorte que les signaux de réception (12) de la série de signaux de réception sont superposés avec différentes valeurs de décalage à l'intérieur d'une plage de valeurs définie,
en particulier le signal de polarisation (10) étant exempt de valeur moyenne pendant la période occupée par la série de signaux de réception,
• une numérisation de la série de signaux d'entrée d'ADC en signaux numériques d'une série de signaux numériques au moyen d'un convertisseur analogique-numérique (17), appelé ci-après ADC, en particulier du type ADC entrelacé ou ADC pipeline, et
• un traitement de la série de signaux numériques, à savoir une sommation ou une moyenne des signaux numériques sur la série de signaux numériques afin d'en déduire la distance par rapport à l'objet cible, la détermination de la distance étant basée sur le procédé de mesure du temps de propagation des impulsions.

2. Procédé de mesure de distance selon la revendication 1,
**caractérisé en ce que**
les différentes valeurs de décalage sont prises en compte lors du traitement de la série de signaux numériques afin de compenser une non-linéarité intégrale moyenne (8) de l'ADC en fonction d'une valeur de signal d'un signal d'entrée d'ADC (11).

3. Procédé de mesure de distance selon la revendication 1 ou 2,
**caractérisé en ce que**
le signal de polarisation (10) est conçu comme un signal avec une composante oscillante à basse fréquence, en particulier un signal sinusoïdal, un signal en dents de scie, un signal en escalier, un signal triangulaire ou un signal trapézoïdal.

4. Procédé de mesure de distance selon l'une des revendications précédentes,
**caractérisé en ce que**
le signal de polarisation (10) est généré par au moins l'une des mesures suivantes :
• un ajout de différentes valeurs DC discrètes à un signal de mesure effectivement généré par la série de signaux de réception à différents instants du signal de mesure effectivement généré, en particulier réglé par un convertisseur numérique-analogique (19), appelé ci-après DAC,
• un décalage périodique des niveaux de décalage de la tension de mode commun de l'ADC (17), et
• un générateur de bruit pour générer un signal supplémentaire variable au signal de mesure effectivement généré.

5. Procédé de mesure de distance selon l'une des revendications précédentes,
**caractérisé en ce que**
la plage de valeurs du signal de polarisation (10) est réglée, en particulier au moyen d'un FPGA ou d'un microprocesseur (20), sur la base
• d'une précision de mesure définie pour la détermination de la distance, et/ou
• d'une valeur de signal mesurée d'un signal de réception (12).

6. Module électronique de mesure de distance par laser, en particulier pour une utilisation dans un appareil de mesure de distance, en particulier réalisé sous la forme d'un laser tracker, d'un tachymètre, d'un scanner laser ou d'un profileur, pour déterminer une distance par rapport à un objet cible, comprenant :
• un canal d'émission avec une unité d'émission pour générer des signaux d'émission d'une série de signaux d'émission au moyen d'un rayonnement de mesure laser pulsé,
• un canal de réception (14) avec une unité de réception (15) pour la réception d'au moins des parties des signaux d'émission de la série de signaux d'émission réfléchis sur l'objet cible sous la forme de signaux de réception (12) d'une série de signaux de réception,
le module de mesure de distance par laser étant réalisé de telle sorte que
• un signal de polarisation (10) variant de manière définie est généré, et
• la série de signaux de réception est superposée avec le signal de polarisation (10), de sorte qu'une série de signaux d'entrée d'ADC est générée,
la valeur du signal de polarisation (10) variant dans le temps de telle sorte que les signaux de réception (12) de la série de signaux de réception sont superposés avec différentes valeurs de décalage à l'intérieur d'une plage de valeurs définie,
en particulier le signal de décalage (10) étant exempt de valeur moyenne pendant la période occupée par la série de signaux de réception,
le module de mesure de distance par laser présentant en outre :
• un circuit de réception pour une numérisation de la série de signaux d'entrée ADC en signaux numériques d'une série de signaux numériques au moyen d'un convertisseur analogique-numérique (17), appelé ci-après ADC, en particulier du type ADC entrelacé ou ADC pipeline, et
• une unité de contrôle et de commande pour une détermination de la distance par rapport à l'objet cible sur la base d'un traitement de la série de signaux numériques, à savoir une sommation ou une moyenne des signaux numériques sur la série de signaux numériques, la détermination de la distance étant basée sur le procédé de mesure du temps de propagation des impulsions.

7. Module de mesure de distance par laser selon la revendication 6,
**caractérisé en ce que**
les différentes valeurs de décalage lors du traitement de la série de signaux numériques sont prises en compte par l'unité de contrôle et de commande afin de compenser une non-linéarité intégrale moyenne (8) de l'ADC en fonction d'une valeur de signal d'un signal d'entrée d'ADC (11).

8. Module de mesure de distance par laser selon la revendication 6 ou 7,
**caractérisé en ce que**
le signal de polarisation (10) est conçu comme un signal avec une composante oscillante à basse fréquence, en particulier un signal sinusoïdal, un signal en dents de scie, un signal en escalier, un signal triangulaire ou un signal trapézoïdal.

9. Module de mesure de distance par laser selon l'une des revendications 6 à 8,
**caractérisé en ce que**
le signal de polarisation (10) est généré par au moins l'une des mesures suivantes :
• un ajout de différentes valeurs DC discrètes à un signal de mesure effectivement généré par la série de signaux de réception à différents instants du signal de mesure effectivement généré, en particulier réglé par un convertisseur numérique-analogique (19), appelé ci-après DAC,
• un décalage périodique des niveaux de décalage de la tension de mode commun de l'ADC (17), et
• un générateur de bruit pour générer un signal supplémentaire variable au signal de mesure effectivement généré.

10. Module de mesure de distance par laser selon l'une des revendications 6 à 9,
**caractérisé en ce que**
la plage de valeurs du signal de polarisation (10) est réglée, en particulier au moyen d'un FPGA ou d'un microprocesseur (20), sur la base
• d'une précision de mesure définie pour la détermination de la distance, et/ou
• d'une valeur de signal mesurée d'un signal de réception (12).

11. Module de mesure de distance par laser selon l'une des revendications 6 à 10,
**caractérisé en ce que**
le module de mesure de distance par laser est conçu de telle sorte que l'ADC (17) génère une trame d'échantillonnage ADC au moyen d'au moins deux étages de conversion ADC, dans lequel
• la trame d'échantillonnage ADC définit, par rapport à un signal de réception (12), une trame d'échantillonnage de signal initiale avec au moins un point d'échantillonnage initial du signal de réception (12), et
• les signaux de réception (12) de la série de signaux de réception sont décalés dans le temps par rapport à la trame d'échantillonnage ADC au moyen d'un premier décalage temporel de telle sorte que ledit au moins un point d'échantillonnage initial soit détecté au moins une fois par un premier étage de conversion ADC et au moins une fois par un deuxième étage de conversion ADC,
en particulier, les signaux de réception (12) de la série de signaux de réception étant en outre décalés dans le temps par rapport à la trame d'échantillonnage ADC au moyen d'un deuxième décalage temporel, de sorte qu'une pluralité de points d'échantillonnage secondaires des signaux de réception, décalés chacun d'une fraction de la durée de période de l'horloge ADC, apparaissent dans une zone d'échantillonnage définie autour dudit au moins un point d'échantillonnage initial et que différentes positions de signal autour dudit au moins un point d'échantillonnage initial soient ainsi échantillonnées avec une valeur de signal variable.
